Europäisches Patentamt

European Patent Office

Office européen des brevets

(11) Publication number: **0 513 665 A1**

# EUROPEAN PATENT APPLICATION

(21) Application number: **92107723.6**

(22) Date of filing: **07.05.92**

(51) Int. Cl.⁵: **G11C 29/00**

(30) Priority: **17.05.91 JP 141370/91**

(43) Date of publication of application:
**19.11.92 Bulletin 92/47**

(84) Designated Contracting States:
**DE FR GB**

(71) Applicant: **NEC CORPORATION**
**7-1, Shiba 5-chome Minato-ku**
**Tokyo 108-01(JP)**

(72) Inventor: **Monden, Junji, c/o NEC Corporation**
**7-1, Shiba 5-chome**
**Minato-ku, Tokyo(JP)**

(74) Representative: **Glawe, Delfs, Moll & Partner**
**Patentanwälte**
**Postfach 26 01 62 Liebherrstrasse 20**
**W-8000 München 26(DE)**

(54) **Semiconductor memory device having precharge control circuit for prohibiting digit line pair from precharging after replacement with redundant digit line pair.**

(57) A static type random access memory device is rescued from a defective digit line pair by replacing it with a redundant digit line pair (RDLP) coupled with redundant memory cells (RM1 to RMm) , and a precharging unit (14) supplies current to all of the digit line pairs and the redundant digit line pair even if the defective digit line pair is replaced with the redundant digit line pair, wherein precharging transistors (Q11/ Q12) coupled with the defective digit line pair are forcibly turned off by applying a constant voltage level (GND) to the gate electrodes thereof upon the replacement so that leakage current does not flow from the defective digit line pair into a ground voltage source.

Fig. 2

FIELD OF THE INVENTION

This invention relates to a semiconductor memory device and, more particularly, to a precharge control circuit for prohibiting a digit line pair from precharging after replacement with a redundant digit line pair.

DESCRIPTION OF THE RELATED ART

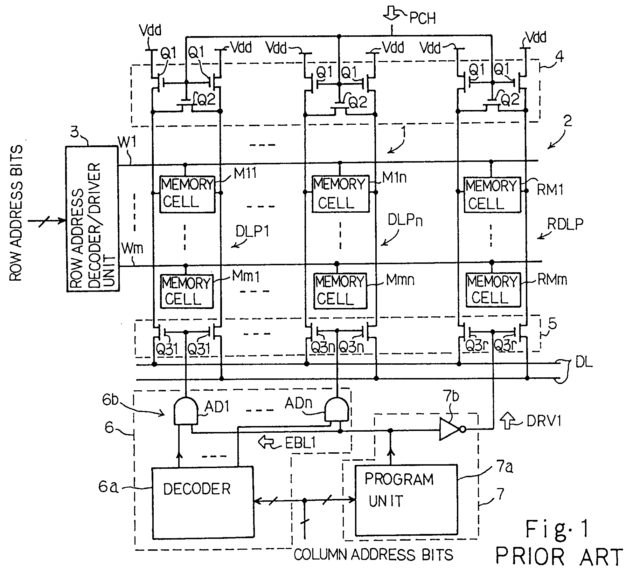

In order to rescue a semiconductor memory device containing a defective memory cell, redundant technologies are applied to the semiconductor memory device. Fig. 1 shows a typical example of a static type random access memory device applied with the redundant technologies, and largely comprises a regular memory cell array 1, a redundant memory cell array 2 and a peripheral circuit group associated with the regular and redundant memory cell arrays 1 and 2. The regular memory cell array 1 is implemented by a plurality of memory cells M11, M1n, Mm1 and Mmn arranged in rows and columns, and a column of redundant memory cells RM1 to RMm form the redundant memory cell array 2. Though not shown in the drawings, each of the regular memory cells M11 to Mmn and the redundant memory cells RM1 to RMm is of a flip flop type storing a data bit in the form of differential voltage level between two memory nodes thereof.

A plurality of word lines W1 to Wm are associated with the rows of the regular memory cell array 1 as well as the redundant memory cells RM1 to RMm, and are selectively driven to an active level for selecting a row of the regular memory cells M11 to Mmn and one of the redundant memory cells RM1 to RMm. A row address decoder/ driver unit 3 is provided in association with the word lines W1 to Wm, and is responsive to row address bits so as to lift one of the word lines W1 to Wm to the active level.

A plurality of digit line pairs DLP1 to DLPn are respectively coupled with the columns of the regular memory cell array 1, and a redundant digit line pair RDLP is coupled with the column of the redundant memory cells RM1 to RMm. When one of the word lines W1 to Wm is driven to the active level, the associated row of the regular memory cells and one of the redundant memory cells RM1 to RMm are electrically connected with the digit line pairs DLP1 to DLPn and the redundant digit line pair RDLP, respectively.

A precharging circuit 4 is coupled between a positive power voltage line Vdd and the digit line pairs DLP1 to DLPn and the redundant digit line pair RDLP, and precharging transistors Q1 and balancing transistors Q2 as a whole constitute the precharging circuit 4. All of the precharging and balancing transistors Q1 and Q2 are concurrently responsive to a precharging signal PCH, and allow the digit line pairs DLP1 to DLPn and the redundant digit line pair RDLP to be adjusted to a precharging level. A column selector unit 5 is coupled between a data line pair DL and the digit line pairs DLP1 to DLPn and the redundant digit line pair RDLP, and transfer transistors Q31, Q3n and Q3r form in combination the column selector unit 5. A column address decoder/ driver unit 6 is provided in association with the column selector unit 5, and comprises an address decoder 6a and a driver 6b implemented by AND gates AD1 to ADn. The address decoder 6a is responsive to column address bits indicative of a column address assigned to one of the regular digit line pairs DLP1 to DLPn, and supplies logic "1" level corresponding to a high voltage level to one of the AND gates AD1 to ADn. Since the AND gates AD1 to ADn are respectively associated with the regular digit line pairs DLP1 to DLPn, the AND gate supplied with logic "1" level allows one of the regular digit line pairs DLP1 to DLPn to be coupled with the data line pair DL in the presence of a first enable signal EBL1 of logic "1" level.

A redundant control unit 7 is provided in association with the redundant memory cell array 2 as well as the redundant digit line pair RDLP, and comprises a program unit 7a and an inverter 7b. If one of the regular memory cells M11 to Mmn or one of the digit line pairs DLP1 to DLPn is found to be defective in a diagnosis carried out in the manufacturing factory, the column address assigned to the associated digit line pair is memorized in the program unit 7a by selectively breaking fuse elements for replacing the defective digit line pair with the redundant digit line pair RDLP. The column address bits are further supplied to the program unit 7a, and the program unit 7a compares the column address indicated by the column address bits with the column address stored therein. The program unit 7a shifts the first enable signal EBL1 between active logic "1" level and inactive logic "0" level corresponding to a low voltage level depending upon the comparing result. The first enable signal EBL1 is supplied to not only the driver 6b but also the inverter 7b, and the inverter 7b shifts a driving signal DRV1 between the active high voltage level and the inactive low voltage level depending upon the first enable signal EBL1.

The prior art static type random access memory device thus arranged behaves as follows. If the prior art static type random access memory device is excellent, any column address is not memorized in the program unit 7a after the diagnosis, and the program unit 7a shifts the first enable signal EBL1 to active logic "1" level at all times. Therefore, the AND gates AD1 to ADn are enabled with the first enable signal EBL1, and one of the AND gates AD1 to ADn allows the selector unit 5 to interconnect one of the digit line pairs DLP1 to DLPn and the data line pair DL at every access. However, the inverter 7b shifts the driving signal DRV1 to the inactive low voltage level at all times, and the redundant digit line pair RDLP is never coupled with the data line pair DL. In this situation, a data bit is read out from one of the regular memory cells M11 to Mmn coupled with the activated word line through the associated digit line pair to the data line pair DL or written into one of the regular memory cells M11 to Mmn.

However, if a defective memory cell or a defective digit line pair is incorporated in the regular memory cell array 1, the column address is memorized in the program unit 7a before delivery from the factory, and the column of the regular memory cell array 1 is replaced with the redundant memory cells RM1 to RMm. After the replacement, the prior art static type random access memory device behaves as follows.

First, the precharging signal PCH allows the precharging and balancing transistors Q1 and Q2 to turn on, and all of the digit line pairs DLP1 to DLPn and the redundant digit line pair RDLP are charged to the precharging level. The row address decoder/ driver unit 3 drives one of the word lines W1 to Wm to the active level, and the associated row of the regular memory cells and one of the redundant memory cells RM1 to RMm are respectively coupled with the digit line pairs DLP1 to DLPn and the redundant digit line pair RDLP. Small differential voltage levels take place on the digit line pairs DLP1 to DLPn and the redundant digit line pair RDLP, respectively. If the column address indicted by the column address bits is different from the column address stored in the program unit 7a, the program unit 7a produces the first enable signal EBL1 of logic "1" level, and the inverter 7b causes the driving signal DRV1 to remain in the inactive low. Then, one of the AND gates AD1 to ADn causes the associated transfer gates Q31 or Q3n to turn on, and a data bit is transferred between the data line pair DL and the selected digit line pair. If the static type random access memory device is in a read-out phase of operation, the data bit is read out through the data line pair DL to the outside thereof. On the other hand, if the static type random access memory device is in a write-in phase of operation, the data bit on the selected digit line pair is written into the memory cell coupled with the activated word line. While the static type random access memory device carries out the read-out or write-in phase of operation, the inverter 7b continuously supplies the driving signal DRV1 of the inactive low voltage level to the transfer gates Q3r, and, for this reason, the redundant digit line pair RDLP is isolated from the data line pair DL.

However, if the column address indicated by the column address bits is matched with the column address stored in the program unit 7a, the program unit 7a shifts the first enable signal EBL1 to inactive logic "0" level, and all of the AND gates AD1 to ADn are disabled. Then, any digit line pair is never coupled with the data line pair DL. However, with the first enable signal EBL1 of in active logic "0" level corresponding to the low voltage level, the inverter 7b shifts the driving signal DRV1 to the active high voltage level, and the transfer gates Q3r turn on so that the redundant digit line pair RDLP is coupled with the data line pair DL. If the static type random access memory device is in the read-out phase of operation, the data bit stored in the redundant memory cell is read out through the data line pair DL to the outside thereof. On the other hand, if the static type random access memory device is in the write-in phase of operation, the data bit on the redundant digit line pair is written into the redundant memory cell coupled with the activated word line.

A problem is encountered in the prior art static type random access memory device in that a large amount of leakage current flows from the digit line pair into a ground voltage source upon access to the regular memory cells coupled thereto. Namely, various kinds of trouble takes place in the static type random access memory device, and undesirable short-circuit between a digit line pair and a ground voltage source is a typical trouble. If such an undesirable short-circuit has taken place, current flows from the defective digit line pair to the ground voltage source in every access, because the precharging circuit 4 couples the positive power voltage line Vdd to the defective digit line pair after the replacement. This results in that current consumption in, especially, standby state is increased, and the redundant technologies can not perfectly rescue the static type random access memory device.

## SUMMARY OF THE INVENTION

It is therefore an important object of the present invention to provide a semiconductor memory device redundant technologies of which allow the device to rescue without sacrifice of current consumption.

To accomplish the object, the present invention proposes to block a defective digit line pair from precharge.

In accordance with the present invention, there is provided a semiconductor memory device fabricated on a single semiconductor chip, comprising: a) a regular memory cell array having a plurality of regular memory cells arranged in rows and columns; b) a plurality of regular digit line pairs respectively coupled with the columns of the plurality of regular memory cells; c) a redundant memory cell array having at least one column of redundant memory cells; d) at least one redundant digit line pair coupled with the at least one column of the redundant memory cells, and replaceable with one of the regular digit line pairs when the one of the regular digit line pairs is defective or coupled with a defective regular memory cell; e) a first selecting means provided in association with the regular memory cell array as well as with the redundant memory cell array for simultaneously selecting a row of the regular memory cells and one of the redundant memory cells from the regular memory cell array and the redundant memory cell array; f) a second selecting means operative to couple one of the plurality of regular digit line pairs and the at least one redundant digit line pair with a data line pair; g) a precharging unit having a plurality of precharging circuits for coupling a source of current with the plurality of regular digit line pairs and the at least one redundant digit line pair; and h) a block means coupled between a constant voltage source and the precharging unit, and supplying a constant voltage level thereto for blocking the regular digit line pair replaced with the at least one redundant digit line pair from the current source.

## BRIEF DESCRIPTION OF THE DRAWINGS

The feature and advantages of the semiconductor memory device according to the present invention will be more clearly understood from the following description taken in conjunction with the accompanying drawings in which:

Fig. 1 is a block diagram showing the arrangement of the prior art semiconductor memory device;

Fig. 2 is a block diagram showing the arrangement of a static type random access memory device according to the present invention;

Fig. 3 is a circuit diagram showing the arrangement of a block unit incorporated in another static type random access memory device according to the present invention;

Fig. 4 is a circuit diagram showing the arrangement of a block unit incorporated in yet another static type random access memory device according to the present invention; and

Fig. 5 is a circuit diagram showing the arrangement of a block unit incorporated in yet another static type random access memory device according to the present invention.

## DESCRIPTION OF THE PREFERRED EMBODIMENTS

### First Embodiment

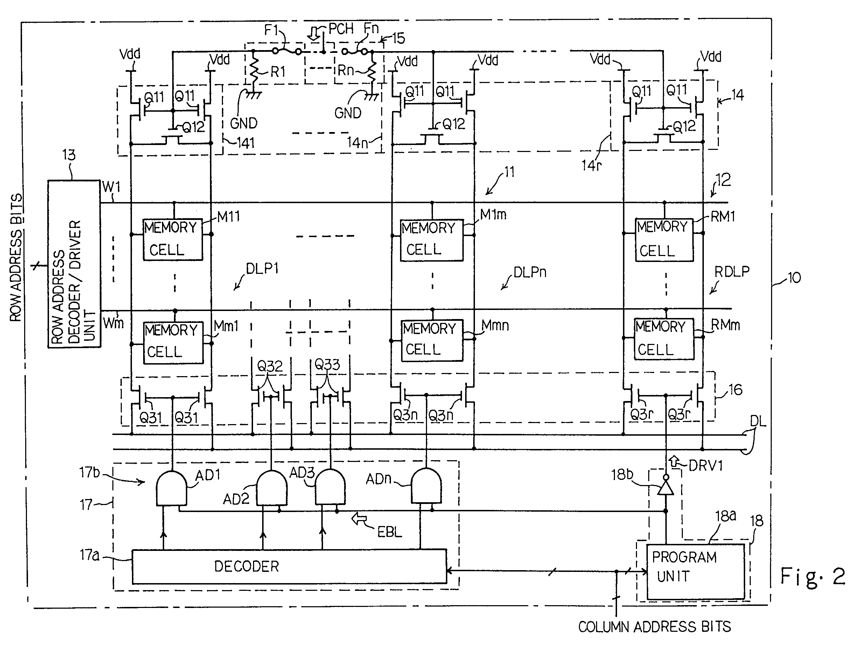

Referring to Fig. 2 of the drawings, a static type random access memory device embodying the present invention is fabricated on a single semiconductor chip 10, and largely comprises a regular memory cell array 11, a redundant memory cell array 12 and a peripheral circuit group associated with the regular and redundant memory cell arrays 11 and 12. The regular memory cell array 11 is implemented by a plurality of memory cells M11, M1n, Mm1 and Mmn arranged in rows and columns, and a column of redundant memory cells RM1 to RMm form the redundant memory cell array 12. Each of the regular and redundant memory cells M11 to Mmn and RM1 to RMm is similar in arrangement to that of the prior art static type random access memory device.

A plurality of word lines W1 to Wm are associated with the rows of the regular memory cell array 11 as well as the redundant memory cells RM1 to RMm, and are selectively driven to an active voltage level for selecting a row of the regular memory cells M11 to Mmn and one of the redundant memory cells RM1 to RMm. A row address decoder/driver unit 13 is provided in association with the word lines W1 to Wm, and is responsive to row address bits so as to lift one of the word lines W1 to Wm to the active voltage level.

A plurality of regular digit line pairs DLP1 to DLPn are respectively coupled with the columns of the regular memory cell array 11, and a redundant digit line pair RDLP is coupled with the column of the redundant memory cells RM1 to RMm. When one of the word lines W1 to Wm is driven to the active level, the associated row of the regular memory cells and one of the redundant memory cells RM1 to RMm are electrically connected with the regular digit line pairs DLP1 to DLPn and the redundant digit line pair RDLP, respectively.

A precharging unit 14 is coupled between a positive power voltage line Vdd and the regular digit line pairs DLP1 to DLPn and the redundant digit line pair RDLP, and comprises precharge circuits 141 to 14n and 14r. Each of the precharge circuits 141 to 14n and 14r is implemented by two n-channel enhancement type precharging transistors Q11 and an n-channel enhancement type balancing transistor Q12. All of the n-channel enhancement type precharging and balancing transistors Q11 and Q12 are concurrently responsive to a precharging signal PCH in so far as any digit line pair is replaced with the redundant digit line pair RDLP, and allow the regular digit line pairs DLP1 to DLPn and the redundant digit line pair RDLP to be adjusted to a precharging voltage level. A block unit 15 is provided in association with the precharging circuit 14, and comprises combinations of fuse elements F1 to Fn and resistive elements R1 to Rn. The combinations serve as block circuits, respectively. The combinations are respectively associated with the precharge circuits 141 to 14n, and each of the fuse element F1 to Fn is coupled between the precharging signal line and the gate electrodes of the n-channel enhancement type precharging and balancing transistors Q11 and Q12 of the associated precharging circuit. Each of the resistive elements R1 to Rn is coupled between a source of ground voltage level GND and the gate electrodes of the n-channel enhancement type precharging and balancing transistors Q11 and Q12 of the associated precharging circuit. If one of the regular digit line pairs DLP1 to DLPn is short-circuited with a ground voltage source, the associated fuse element is broken, and the ground voltage level is supplied from the source of ground voltage level GND through the associated resistive element to the gate electrodes of the n-channel enhancement type precharging and balancing transistors Q11 and Q12 of the associated precharging circuit, thereby causing the n-channel enhancement type precharging and balancing transistors Q11 and Q12 to turn off. Each of the resistive elements R1 to Rn provides tens ohms as high as resistive elements incorporated in each regular or redundant memory cell. Therefore, these resistive elements incorporated in excess memory cells are available for the resistive elements R1 to Rn, and only negligible amount of through-current passes through the resistive elements R1 to Rn.

A column selector unit 16 is coupled between a data line pair DL and the regular digit line pairs DLP1 to DLPn and the redundant digit line pair RDLP, and n-channel enhancement type transfer transistors Q31, Q32, Q33, Q3n and Q3r form in combination the column selector unit 16. A column address decoder/ driver unit 17 is provided in association with the column selector unit 16, and comprises an address decoder 17a and a driver 17b implemented by AND gates AD1, AD2, AD3 and ADn. The address decoder 17a is responsive to column address bits indicative of a column address assigned to one of the regular digit line pairs DLP1 to DLPn, and supplies logic "1" level corresponding to a positive high voltage level to one of the AND gates AD1 to ADn. Since the AND gates AD1 to ADn are respectively associated with the regular digit line pairs DLP1 to DLPn, the AND gate supplied with logic "1" allows one of the regular digit line pairs DLP1 to DLPn to be coupled with the data line pair DL in the presence of a first enable signal EBL1 of logic "1" level.

A redundant control unit 18 is provided in association with the redundant memory cell array 12 as well as the redundant digit line pair RDLP, and comprises a program unit 18a and an inverter 18b.

If one of the regular memory cells M11 to Mmn or one of the regular digit line pairs DLP1 to DLPn is found to be defective in a diagnosis carried out in the manufacturing factory, the column address assigned to the defective digit line pair is memorized in the program unit 18a by selectively breaking fuse elements for replacing the defective digit line pair with the redundant digit line pair RDLP. The column address bits are further supplied to the program unit 18a, and the program unit 18a compares the column address indicated by the column address bits with the column address stored therein. The program unit 18a shifts the first enable signal EBL1 between active logic "1" level and inactive logic "0" level corresponding to a low voltage level depending upon the comparing result. The first enable signal EBL1 is supplied to not only the driver 17b but also the inverter 18b, and the inverter 18b complementarily shifts a driving signal DRV1 between the active high voltage level and the inactive low voltage level with respect to the first enable signal EBL1.

The static type random access memory device thus arranged behaves as follows. If the static type random access memory device is excellent, any column address is not memorized in the program unit 18a after the diagnosis, and the program unit 18a shifts the first enable signal EBL1 to active logic "1" level at all times. Therefore, the AND gates AD1 to ADn are enabled with the first enable signal EBL1, and one of the AND gates AD1 to ADn allows the selector unit 16 to interconnect one of the regular digit line pairs DLP1 to DLPn and the data line pair DL at every access. However, the inverter 18b shifts the driving signal DRV1 to the inactive low voltage level, and, for this reason, the redundant digit line pair RDLP is never coupled with the data line pair DL. In this situation, a data bit is read out from one of the regular memory cells M11 to Mmn coupled with the activated word line through the associated regular digit line pair to the data line pair DL or written into one of the regular memory cells M11 to Mmn.

However, if a defective memory cell or a defective digit line pair is incorporated in the regular memory cell array 11, the column address is memorized in the program unit 18a before delivery from the factory, and the defective digit line pair is replaced with the redundant digit line pair RDLP, and, accordingly, the column of the regular memory cells M11 to Mmn are replaced with the redundant memory cells RM1 to RMm. Moreover, one of the fuse elements F1 to Fn associated with the defective digit line pair is broken, and, for this reason, the associated precharging circuit never couples the positive voltage line Vdd with the defective digit line pair, because the associated n-channel enhancement type precharging and balancing transistors Q11 and Q12 are turned off with the ground voltage level.

After the replacement, the static type random access memory device behaves as follows. First, the precharging signal PCH allows the n-channel enhancement type precharging and balancing transistors Q11 and Q12 to turn on; however, the n-channel enhancement type precharging and balancing transistors Q11 and Q12 associated with the defective digit line pair remain off, and the excellent digit line pairs except for the defective digit line pair and the redundant digit line pair RDLP are charged to the precharging level. Thus, no current is supplied to the defective digit line pair, and, for this reason, leakage current is minimized. In other words, the redundant technologies according to the present invention perfectly rescue the static type random access memory device. The row address decoder/ driver unit 13 drives one of the word lines W1 to Wm to the active level, and the associated row of the regular memory cells and one of the redundant memory cells RM1 to RMm are respectively coupled with the associated excellent regular digit line pairs and the redundant digit line pair RDLP. Small differential voltage levels take place on the excellent regular digit line pairs DLP1 to DLPn and the redundant digit line pair RDLP, respectively. If the column address indicted by the column address bits is different from the column address stored in the program unit 18a, the program unit 18a produces the first enable signal EBL1 of logic "1" level, and the inverter 18b causes the driving signal DRV1 to remain in the inactive low voltage level. Then, one of the AND gates AD1 to ADn causes the associated n-channel enhancement type transfer transistors Q31 or Q3n to turn on, and a data bit is transferred between the data line pair DL and the selected regular digit line pair. If the static type random access memory device is in a read-out phase of operation, the data bit is read out through the data line pair DL to the outside thereof. On the other hand, if the static type random access memory device is in a write-in phase of operation, the data bit on the selected regular digit line pair is written into the regular memory cell coupled with the activated word line. While the static type random access memory device carries out the read-out or write-in phase of operation, the inverter 7b continuously supplies the driving signal DRV1 of the inactive low voltage level to the n-channel enhancement type transfer transistors Q3r, and the selector unit 16 isolates the redundant digit line pair RDLP from the data line pair DL.

However, if the column address indicated by the column address bits is matched with the column address stored in the program unit 18a, the program unit 18a shifts the first enable signal EBL1 to inactive logic "0" level, and all of the AND gates AD1 to ADn are disabled. Then, any regular digit line pair is never coupled with the data line pair DL. However, with the first enable signal EBL1 of inactive logic "0" level corresponding to the low voltage level, the inverter 18b shifts the driving signal DRV1 to the active high voltage level, and the n-channel enhancement type transfer transistors Q3r turn on so that the redundant digit line pair RDLP is coupled with the data line pair DL. If the static type random access memory device is in the read-out phase of operation, the data bit stored in the redundant memory cell is read out through the data line pair DL to the outside thereof. On the other hand, if the static type random access memory device is in the write-in phase of operation, the data bit on the redundant digit line pair is written into the redundant memory cell coupled with the activated word line.

Second Embodiment

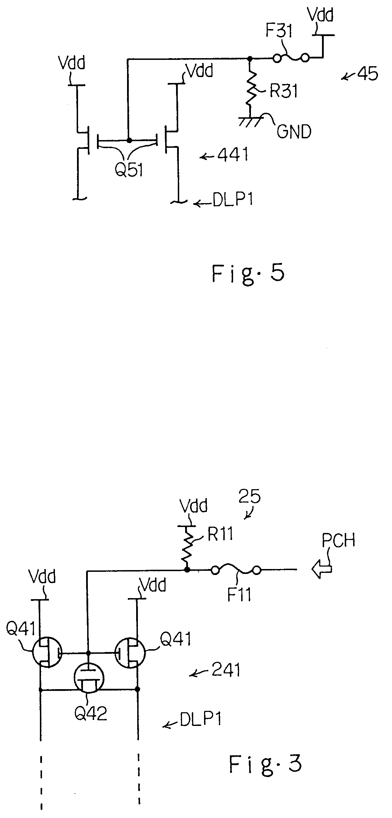

Turning to Fig. 3, a part of a block unit 25 is incorporated in another static type random access memory device embodying the present invention together with a precharging unit 241. Other circuit components are similar to those of the static type random access memory device implementing the first embodiment, and no further description on the other circuit arrangement is incorporated hereinbelow for the sake of simplicity. The precharging unit 241 is implemented by p-channel enhancement type precharging and balancing transistors Q41 and Q42, and the gate electrodes of the p-channel enhancement type precharging and balancing transistors Q41 and Q42 are coupled through the block unit 25 with a precharging signal line. Since a p-channel enhancement type field effect transistor is turned off with a positive high voltage level with respect to the drain node thereof, each combination of the block unit 25 comprises a fuse element F11 coupled between the precharging signal line and the gate electrodes of the p-channel enhancement type precharging and balancing transistors Q41 and Q42, and a resistive element R11 coupled between the positive power voltage line Vdd and the gate electrodes.

If the static type random access memory device is excellent, any fuse element is broken, and a precharging signal PCH of an active low voltage level is distributed to all of the p-channel enhancement type precharging and balancing transistors Q41 and Q42. However, if the regular digit line pair DLP1 is defective, the fuse element F11 is broken, and the positive power voltage level Vdd is continuously supplied to the gate electrodes of the p-channel enhancement type precharging and balancing transistors Q41 and Q42. Therefore, the defective digit line pair DLP1 is isolated from the positive power voltage level Vdd, and any leakage current flows from the defective digit line pair DLP1.

Third Embodiment

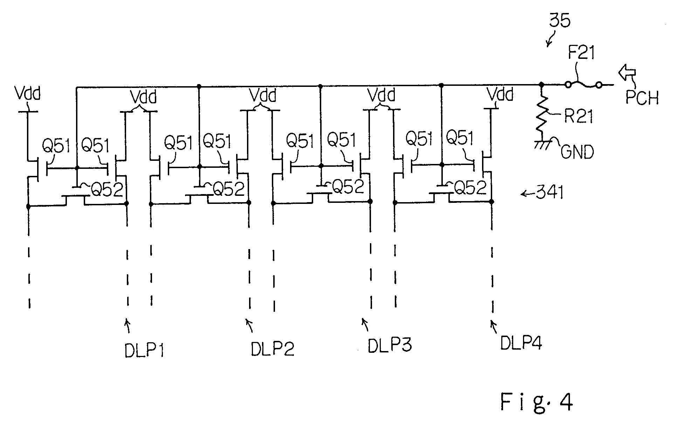

Turning to Fig. 4 of the drawings, a combination of a fuse element F21 and a resistive element R21 form a part of a block unit 35, and is associated with a precharging circuit 341 associated with fourth regular digit line pairs DLP1, DLP2, DLP3 and DLP4. In this instance, the four regular digit line pairs DLP1 to DLP4 are simultaneously replaced with four redundant digit line pairs, and, accordingly, the combination of the fuse and resistive elements F21 and R21 is provided for every four regular digit line pairs. Since the precharging and balancing transistors Q51 and Q52 are of an n-channel enhancement type, the resistive element R21 is coupled with a ground voltage line GND.

The other circuit components as well as the circuit behavior are similar to those of the first embodiment, and description is omitted for avoiding undesirable repetition.

Fourth Embodiment

Turning to Fig. 5 of the drawings, yet another block unit 45 is provided in association with a precharging circuit 441, and the precharging circuit 441 is implemented by n-channel enhancement type precharging transistors Q51 coupled between a positive power voltage line Vdd and a regular digit line pair DLP1. A combination of a fuse element F31 and a resistive element R31 forms a part of the block unit 45, and is associated with the precharging unit 441. Since the gate electrodes of the n-channel enhancement type precharging transistors Q51 are coupled through the block unit 45 with the positive power voltage line Vdd, the n-channel enhancement type precharging transistors Q51 are turned on at all times, and current is supplied to the regular digit line pair DLP1 and other regular digit line pairs (not shown) as long as any one, of the regular digit line pairs is not replaced with a redundant digit line pair. However, if the regular digit line pair DLP1 is replaced with a redundant digit line pair, the fuse element F31 is broken, and the ground voltage level is supplied from a ground voltage line GND through the resistive element R31 to the gate electrodes of the n-channel enhancement type precharging transistors Q51 so as to isolate the regular digit line pair DLP1 from the positive power voltage line Vdd. However, other circuit components and circuit behavior are similar to those of the first embodiment, and no further description is made thereon.

Although particular embodiments of the present invention have been shown and described, it will be obvious to those skilled in the art that various changes and modifications may be made without departing from the spirit and scope of the present invention. For example, the regular and redundant memory cells may be another type of static random access memory or a dynamic type random access memory.

**Claims**

1. A semiconductor memory device fabricated on a single semiconductor chip (10), comprising:

a) a regular memory cell array (11) having a plurality of regular memory cells (M11 to Mmn) arranged in rows and columns;

b) a plurality of regular digit line pairs (DLP1 to DLPn) respectively coupled with the columns of said plurality of regular memory cells;

c) a redundant memory cell array (12) having at least one column of redundant memory cells replaceable;

d) at least one redundant digit line pair (RDLP) coupled with said at least one column of said redundant memory cells, and replaceable with one of said regular digit line pairs when said one of said regular digit line is defective or coupled with a defective regular memory cell;

e) a first selecting means (13/ W1 to Wm) provided in association with said regular memory cell array as well as with said redundant memory cell array for simultaneously selecting a row of said regular memory cells and one of said redundant memory cells from said regular memory cell array and said redundant memory cell array;

f) a second selecting means (16/ 17/ 18) operative to couple one of said plurality of regular digit line pairs and said at least one redundant digit line pair with a data line pair (DL); and

g) a precharging unit (14) having a plurality of precharging circuits (141 to 14r; 241; 341; 441) for coupling a source of current (Vdd) with said plurality of regular digit line pairs and said at least one redundant digit line pair, characterized by

h) a block means (15; 25; 35; 45) coupled between a constant voltage source (GND; Vdd) and said precharging unit, and supplying a constant voltage level thereto for blocking the regular digit line pair replaced with said at least one redundant digit line pair from said current source.

2.  A semiconductor memory device as set forth in claim 1, in which said plurality of precharging circuits (141 to 14r; 241; 441) are respectively coupled with said plurality of regular digit line pairs and said at least one redundant digit line pair, and said block means comprises a plurality of block circuits respectively associated with the plurality of precharging circuits respectively coupled with said plurality of regular digit line pairs.

3.  A semiconductor memory device as set forth in claim 2, in which each of said plurality of block circuits comprises a fuse element (F1/ Fn; F11; F31) coupled between the associated precharging circuit and a first source of voltage level (PCH; Vdd) for producing an enabling voltage level causing said associated precharging circuit to couple said source of current with the associated regular digit line pair, and a resistive element (R1/ Rn; R11; R31) coupled between said associated precharging circuit and a second source of voltage level (GND; Vdd) for producing a prohibiting voltage level causing said associated precharging circuit to isolate said associated regular digit line pair from said source of current.

4.  A semiconductor memory device as set forth in claim 3, in which said enabling voltage level is an active level of a precharging signal (PCH), and in which each of said precharging circuits comprises a pair of precharging transistors (Q11; Q41) coupled between said source of current and said associated regular digit line pair, and a balancing transistor (Q12; Q42) coupled between drain nodes of said pair of precharging transistors.

5.  A semiconductor memory device as set forth in claim 3, in which said enabling voltage level is supplied from a constant voltage source (Vdd) , and in which each of said precharging circuits comprises a pair of precharging transistors (Q51) coupled between said source of current and said associated regular digit line pair.

6.  A semiconductor memory device as set forth in claim 1, in which said plurality of precharging circuits (341) are respectively coupled with said plurality of regular digit line pairs and said at least one redundant digit line pair, and said block means comprises at least one block circuit (35) associated with precharging circuits selected from said plurality of precharging circuits.

7.  A semiconductor memory device as set forth in claim 6, in which said at least one block circuit comprises a fuse element (F21) coupled between the associated precharging circuits (341) and a first source of voltage level (PCH) for producing an enabling voltage level causing said associated precharging circuits to couple said source of current with the associated regular digit line pairs, and a resistive element (R21) coupled between said associated precharging circuits and a second source of voltage level (GND) for producing a prohibiting voltage level causing said associated precharging circuits to isolate said associated regular digit line pairs from said source of current.

8.  A semiconductor memory device as set forth in claim 7, in which said enabling voltage level is an active level of a precharging signal (PCH).

9.  A semiconductor memory device as set forth in claim 8, in which each of said precharging circuits (341) comprises a pair of precharging transistors (Q51) coupled between said source of current and said associated regular digit line pair, and a balancing transistor (Q52) coupled between drain nodes of said pair of precharging transistors.

Fig. 1
PRIOR ART

Fig. 2

Fig. 5

Fig. 3

Fig. 4

## DOCUMENTS CONSIDERED TO BE RELEVANT

EP 92107723.6

| Category | Citation of document with indication, where appropriate, of relevant passages | Relevant to claim | CLASSIFICATION OF THE APPLICATION (Int. Cl.5) |
|---|---|---|---|
| P,A | DE - A - 4 105 104 (MITSUBISHI) * Page 4, lines 40-57; claims 1-5,7-9,13-18; fig. 4,9 * | 1,2,3, 4,5,7, 8 | G 11 C 29/00 |
| A | US - A - 4 228 528 (CENKER et al.) * Column 3, line 56 - column 4, line 59; claims 1-3,5,6; fig. 3 * | 1,2,3, 7 | |
| A | US - A - 4 630 241 (KOBAYASHI et al.) * Column 3, line 44 - column 4, line 2; claims 1,3 * | 1,3 | |

**TECHNICAL FIELDS SEARCHED (Int. Cl.5)**

G 11 C

The present search report has been drawn up for all claims

| Place of search | Date of completion of the search | Examiner |
|---|---|---|
| VIENNA | 14-08-1992 | MEHLMAUER |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)